# EUROPÄISCHE PATENTSCHRIFT

(11) **EP 2 786 417 B1**
(45) Veröffentlichungstag und Bekanntmachung des Hinweises auf die Patenterteilung: **05.12.2018**
(21) Anmeldenummer: 12769618.5
(22) Anmeldetag: 06.09.2012
(51) Int. Cl.: H01L 29/861, H01L 29/06

(54) **HALBLEITERBAUELEMENT MIT OPTIMIERTEM RANDABSCHLUSS**
SEMICONDUCTOR COMPONENT WITH OPTIMIZED EDGE TERMINATION
COMPOSANT SEMI-CONDUCTEUR À PROTECTION DES BORDS OPTIMISÉE

(30) Priorität: 30.11.2011 DE 102011087487
(43) Veröffentlichungstag der Anmeldung: 08.10.2014
(73) Patentinhaber: Infineon Technologies Bipolar GmbH & Co. KG, 59581 Warstein (DE)
(72) Erfinder: BARTHELMESS, Reiner, 59494 Soest (DE); SCHULZE, Hans-Joachim, 82024 Taufkirchen (DE); KELLNER-WERDEHAUSEN, Uwe, 97359 Leutenbach (DE); LUTZ, Josef, 09126 Chemnitz (DE); BASLER, Thomas, 09126 Chemnitz (DE)
(74) Vertreter: Lohmanns, Bernard
(86) Internationale Anmeldenummer: PCT/EP2012/067441
(87) Internationale Veröffentlichungsnummer: WO 2013/079235

(56) Entgegenhaltungen:
- DE-A1- 10 361 136
- JP-A- 60 066 477
- US-A- 4 220 963
- US-A- 6 037 632
- US-A1- 2009 267 200
- HEINZE B ET AL: "Ruggedness analysis of 3.3kV high voltage diodes considering various buffer structures and edge terminations", MICROELECTRONICS JOURNAL, MACKINTOSH PUBLICATIONS LTD. LUTON, GB, Bd. 39, Nr. 6, 1. Juni 2008 (2008-06-01), Seiten 868-877, XP022688211, ISSN: 0026-2692, DOI: 10.1016/J.MEJO.2007.11.023 [gefunden am 2008-01-28]

## Beschreibung

Die vorliegende Erfindung betrifft ein Halbleiterbauelement, insbesondere eine Scheibenzellendiode, nach dem Oberbegriff des Anspruchs 1.

Es ist an sich bekannt, dass die Randgestaltung von Halbleiterbauelementen, insbesondere Leistungshalbleiterbauelementen, einen erheblichen Einfluss auf die erzielbare Sperrspannungsfestigkeit des Bauelements hat. Allgemein lassen sich die Randstrukturen von Halbleiterbauelementen in zwei Hauptgruppen unterteilen: Randstrukturen, bei denen durch eine Randabschrägung ein Winkel am Halbleiterkörper eingestellt wird, unter dem beispielsweise ein pn-Übergang die Halbleiteroberfläche schneidet, und Randstrukturen mit ebener Halbleiteroberfläche, die als planare Randstrukturen bezeichnet werden. Derartige Randstrukturen sind beispielsweise aus LUTZ, Josef, Halbleiter-Leistungsbauelemente; 1 Aufl. Berlin; Springer-Verlag; 2006; Seiten 80 bis 85 bekannt.

Die Randabschrägung im Randbereich des Halbleiterbauelements kann an dem Halbleiterkörper sowohl mechanisch zum Beispiel durch Schleifen oder Läppen sowie auch auf chemischem Wege durch gezieltes Ätzen hergestellt werden. Der Winkel der Randabschrägung wird allgemein in Bezug auf einen Übergang von einer höher dotierten auf eine niedriger dotierte Halbleiterzone definiert, wobei von einem positiven Winkel gesprochen wird, wenn der Durchmesser des Halbleiterkörpers in Richtung von der höher dotierten zur niedriger dotierten Halbleiterzone abnimmt, andernfalls von einem negativen Winkel.

Bei typischen Halbleiterbauelementen, insbesondere Scheibenzellendioden, ist als Randabschluss üblicherweise ein positiver Winkel vorgesehen. Dieser Winkel bedingt eine Aufweitung der Raumladungszone, so dass diese bei heute üblichen Dimensionierungen der Grunddotierung einer Innenzone des Halbleiterkörpers schon bei relativ geringen angelegten Sperrspannungen an den hoch n-dotierten Emitter anstößt. Dies führt dazu, dass im Bereich des positiven Winkels am Übergang zwischen dem schwach n-dotierten und dem hoch n-dotierten Gebiet stark überhöhte elektrische Feldstärken auftreten. Diese Feldspitzen sind besonders dann kritisch, wenn beim Abschalten mit hoher Kommutierungssteilheit eine hohe Dichte freier Elektronen an dieser Stelle auftritt und den Feldverlauf lokal aufsteilt. Dies kann zum Ausfall des Halbleiterbauelements führen. Der Winkelbereich für eine positive Anschrägung liegt typischerweise zwischen etwa 25° bis etwa 50°.

Insbesondere ist bei Halbleiterbauelementen mit einer Randabschrägung positiven Winkels die randseitige Anodenfläche verhältnismäßig größer als die randseitige Kathodenfläche, so dass im Durchlassfall am Rand des Halbleiterkörpers kathodenseitig eine erhöhte Stromdichte auftreten kann. Da die gespeicherte Ladung proportional zur Stromdichte ist, wird ein dynamischer Avalanche im Bereich des Rands zuerst auftreten.

Bisher ist als Gegenmaßnahme vorgesehen, im Außen- bzw. Randbereich des hoch n-dotierten Emitters des Halbleiterbauelements zusätzlich zur positiven Randabschrägung eine zweite Randabschrägung mit einem flacheren Winkel, insbesondere einem flachen negativen Winkel, in den Halbleiterkörper zu ätzen. Dies erfolgt üblicherweise mittels einer Schleuderätzung. Nachteilig hierbei ist jedoch, dass dieses Verfahren zu einer schwer reproduzierbaren Randkontur führt und somit auch zu Streuungen der elektrischen Eigenschaften von Bauelement zu Bauelement. Insbesondere können vereinzelt Bauelemente mit lokalen Schwachpunkten, insbesondere Feldstärkeüberhöhungen, an der genannten Stelle auftreten.

Die US 4 220 963 A offenbart ein Halbleiterbauelement gemäß dem Oberbegriff des Anspruchs 1. Aus der JP 60 066477 A ist eine zweite Randabschrägung entlang des Randes eines Halbleiterbauelements bekannt. Die US 6 037 632 A sowie auch die US 2009/0267200 A1 und die DE 103 61 136 A1 offenbaren einen Leistungshalbleiter mit einer vergrabenen Halbleiterzone.

Vor diesem Hintergrund hat sich die vorliegende Erfindung die Aufgabe gestellt, ein Halbleiterbauelement zur Verfügung zu stellen, bei dem überhöhte Feldstärkespitzen im Randbereich, die während des Abschaltvorgangs des Halbleiterbauelements auftreten, gezielt vermieden werden. Ferner sollen die Halbleiterbauelemente einfacher und genauer zu reproduzieren sein und geringere Streuungen der elektrischen Eigenschaften aufweisen, insbesondere während der Ausschalt- bzw. Ausräumphase des Halbleiterbauelements.

Diese Aufgabe wird durch ein Halbleiterbauelement, insbesondere eine Scheibenzellendiode, mit den Merkmalen des Anspruchs 1 gelöst. Weitere, besonders vorteilhafte Ausgestaltungen der Erfindung offenbaren die Unteransprüche.

Als vergraben im Sinne der vorliegenden Erfindung wird eine Halbleiterzone bezeichnet, wenn sie weder an die erste noch an die zweite Seite des Halbleiterkörpers angrenzt, sondern in vertikaler Richtung im Inneren des Halbleiterkörpers angeordnet ist. Lediglich an den Rand des Halbleiterkörpers kann die vergrabene Halbleiterzone im Sinne der vorliegenden Erfindung heranreichen.

Die wenigstens eine vergrabene Halbleiterzone des zweiten Leitungstyps bewirkt im Durchlassfall des Halbleiterbauteils eine Reduzierung der Stromdichte am Rand des Halbleiterkörpers. Hierdurch wird ein dynamischer Avalanche im Sperrbetrieb des Halbleiterbauelements erst verzögert auftreten. Beim Übergang vom Durchlassfall in den Sperrbetrieb werden die Ladungen in dem Halbleiterkörper ausgeräumt. Erst während dieses sich an den Durchlassfall anschließenden Ausräumvorgang kann ein Avalanche bzw. ein dynamischer Avalanche auftreten. Dieser tritt dann bevorzugt im Randbereich des Halbleiterkörpers auf und nimmt umso kritischere Ausmaße an, je höher die Stromdichte im Randbereich vor dem Ausschalten war. Dies kann durch die vergrabene Halbleiterzone des zweiten Leitungstyps verhindert werden, da diese schon während der Durchlassphase eine hohe Ladungsdichte und damit eine hohe Stromdichte im Randbereich wirksam verhindert.

Kommt es zu einem dynamischen Avalanche, so injiziert die vergrabene Halbleiterzone Ladungsträger des zweiten Ladungstyps, beispielsweise im Fall einer p-Dotierung Löcher, welche die in einer Halbleiterzone des Halbleiterkörpers durch den dynamischen Avalanche erzeugten Ladungsträger, im Fall einer n-dotierten Halbleiterzone Elektronen, wenigstens teilweise kompensieren können. Des Weiteren erlaubt die Herstellung der vergrabenen Halbleiterzone, zum Beispiel mittels einer Vorbelegung oder Ionenimplantation und einem anschließenden Eintreibschritt, eine genaue Reproduzierbarkeit und führt somit zu geringeren Streuungen der elektrischen Eigenschaften der Halbleiterbauelemente.

Die wenigstens eine vergrabene Halbleiterzone ist erfindungsgemäß derart auszulegen bzw. zu dimensionieren, dass sie oberhalb einer bestimmten, vorgebbaren Stromdichte im Halbleiterkörper während des Ausschaltvorgangs Ladungsträger eines Ladungstyps injiziert, die den lokal überhöhten Ladungsträgerstrom des anderen, komplementären Ladungstyps zumindest teilweise kompensiert. Wichtig sind hierfür insbesondere die laterale Erstreckung bzw. Breite und die Dotierungskonzentration der vergrabenen Halbleiterzonen sowie die Dotierungskonzentration der angrenzenden Grunddotierung der Innenzone.

Gemäß einer vorteilhaften Ausgestaltung der Erfindung weist die vergrabene Halbleiterzone eine maximale Dotierungskonzentration bevorzugt zwischen etwa 2x10¹⁶ cm⁻³ und etwa 5x10¹⁷ cm⁻³ auf, wobei ihr Dotierungsprofil vorteilhafterweise vom Gauss-Typ ist. Ferner beträgt ihre laterale Erstreckung bzw. Breite bevorzugt zwischen etwa 1,5 µm bis etwa 15 µm.

Um insbesondere den Rand bzw. den an den Rand des Halbleiterkörpers angrenzenden Randbereich vor überhöhten elektrischen Feldstärken zu schützen, sieht eine Ausgestaltung vor, die vergrabene Halbleiterzone lediglich in einem Außen- bzw. Randbereich des Halbleiterkörpers anzuordnen. Beispielsweise kann die vergrabene Halbleiterzone bei einem scheibenförmigen Halbleiterkörper, zum Beispiel einer Scheibenzellendiode, ringförmig im Außen- bzw. Randbereich des Halbleiterkörpers ausgebildet sein.

In einem nicht erfindungsgemäßen Beispiel ist die vergrabene Halbleiterzone vom Rand des Halbleiterkörpers lateral beabstandet angeordnet. Hierdurch wird verhindert, dass eine am Rand des Halbleiterkörpers auftretende Feldstärkespitze zu nahe an die vergrabene Halbleiterzone kommen kann, was im statischen Sperrfall einen erhöhten Sperrstrom oder sogar eine Verringerung der Sperrspannung zur Folge haben kann. Der laterale Abstand der vergrabenen Halbleiterzone zum Rand des Halbleiterkörpers beträgt vorzugsweise zwischen etwa 30 µm bis etwa 200 µm.

Eine weitere, nicht erfindungsgemäße Ausgestaltung sieht vor, dass zwischen der ersten Halbleiterzone und der Innenzone eine parallel zur ersten Halbleiterzone verlaufende Feldstoppzone des ersten Leitungstyps mit einer Dotierungskonzentration angeordnet ist, die zwischen der Dotierungskonzentration der ersten Halbleiterzone und der Dotierungskonzentration der Innenzone liegt, wobei die Feldstoppzone der vergrabenen Halbleiterzone in Richtung der Innenzone vorgelagert ist. Hierdurch wird in effektiver Weise die statische Sperrfähigkeit des Halbleiterbauelements bei gleicher Dicke der Innenzone erhöht, indem der hochdotierten Halbleiterzone des ersten Leitungstyps mit niedriger Eindringtiefe die Feldstoppzone des ersten Leitungstyps mit höherer Eindringtiefe vorgelagert ist. Das Eindringen des elektrischen Felds in die Feldstoppzone wird erlaubt. Die derart vorgesehene Feldstoppzone wirkt der Feldstärkeüberhöhung am Rand des Halbleiterkörpers durch die im Sperrfall zusätzlich zur Verfügung gestellte Raumladung des zweiten Ladungstyps zusätzlich entgegen. Die Feldstoppzone weist eine Dotierungskonzentration bevorzugt zwischen etwa 5x10¹⁴ cm⁻³ bis etwa 5x10¹⁶ cm⁻³ auf und eine Eindringtiefe von bevorzugt zwischen etwa 10 µm bis etwa 70 µm. Ferner ist das Dotierungsprofil der Feldstoppzone bevorzugt vom Gauss-Typ. Die Feldstoppzone kann in an sich bekannter Weise beispielsweise durch Vorbelegung eines Dotierstoffs, zum Beispiel Phosphor oder Selen für den Fall einer n-dotierten Feldstoppzone, oder Implantation des Dotierstoffs mit nachfolgender Eindiffusion hergestellt werden.

Erfindungsgemäß ist eine zweite Randabschrägung mit einem zweiten Winkel bezüglich des Übergangs von der ersten Halbleiterzone zur Innenzone bzw. zur Feldstoppzone vorgesehen, die sich wenigstens entlang des Rands der ersten Halbleiterzone und der vergrabenen Halbleiterzone erstreckt, wobei der Betrag des zweiten Winkels kleiner ist als der Betrag des ersten Winkels. Vorzugsweise liegt der Betrag des zweiten Winkels zwischen etwa 1° bis etwa 5°. Hierdurch liegt die Austrittsstelle der Raumladungszone an der Seite der ersten Halbleiterzone im Bereich der Feldstoppzone und wird durch die Randabschrägung zum Rand hin verbreitert, wodurch die Höhe der Feldstärkespitze am Rand reduziert wird.

Eine weitere nicht erfindungsgemäße Ausgestaltung sieht vor, dass mehrere vergrabene Halbleiterzonen in einer Ebene angeordnet und lateral zueinander beabstandet sind. Auf diese Weise lässt sich eine besonders hohe Robustheit des Halbleiterbauelements erreichen. Alternativ oder in Ergänzung zu dieser Ausgestaltung kann eine vergrabene Halbleiterzone ebenfalls Unterbrechungen aufweisen, die in Form von Streifen und/oder einer zweidimensionalen Löcheranordnung ausgebildet sind. Die Unterbrechungen bzw. Öffnungen dieser vergrabenen Halbleiterzone betragen bevorzugt maximal 6 µm und besonders bevorzugt etwa 2 µm bis etwa 6 µm. Im Fall der zweidimensionalen Löcheranordnung können die Unterbrechungen bzw. Löcher, die auch als Shorts bezeichnet werden, in einer ganzflächigen vergrabenen Halbleiterzone angeordnet sein, wobei der Durchmesser dieser Shorts auch größer sein kann als 6 µm, bevorzugt bis zu etwa 10 µm. Insbesondere kann der Durchmesser der Shorts ebenfalls zum Rand des Halbleiterkörpers hin variieren, zum Beispiel kleiner werden. Ferner kann sich die mit Unterbrechungen bzw. Öffnungen versehene, vergrabene Halbleiterzone auch über den gesamten Durchmesser des Halbleiterkörpers erstrecken, wodurch sich die Robustheit des Halbleiterbauelements weiter steigern lässt.

Weitere vorteilhafte Einzelheiten und Wirkungen der Erfindung sind im Folgenden anhand von in den Figuren dargestellten Ausführungsbeispielen näher erläutert. Es zeigen:
- Fig. 1: ein Ausschnitt einer Querschnittsseitenansicht eines als Diode ausgebildeten Halbleiterbauelements nach dem Stand der Technik,
- Fig. 2: ein Ausschnitt einer Querschnittsseitenansicht eines ersten nicht erfindungsgemäßen Ausführungsbeispiels eines als Diode ausgebildeten Halbleiterbauelements,
- Fig. 3: ein Ausschnitt einer Querschnittsseitenansicht eines zweiten nicht erfindungsgemäßen Ausführungsbeispiels eines als Diode ausgebildeten Halbleiterbauelements,
- Fig. 4: ein Ausschnitt einer Querschnittsseitenansicht eines dritten nicht erfindungsgemäßen Ausführungsbeispiels eines als Diode ausgebildeten Halbleiterbauelements,
- Fig. 5: ein beispielhaftes Dotierungsprofil des in Fig. 4 dargestellten Halbleiterbauelements,
- Fig. 6: ein Ausschnitt einer Querschnittsseitenansicht eines vierten erfindungsgemäßen Ausführungsbeispiels eines als Diode ausgebildeten Halbleiterbauelements und
- Fig. 7: ein Ausschnitt einer Querschnittsseitenansicht eines fünften, nicht erfindungsgemäßen Ausführungsbeispiels eines als Diode ausgebildeten Halbleiterbauelements.

In den unterschiedlichen Figuren sind gleiche Teile stets mit denselben Bezugszeichen versehen, so dass diese in der Regel auch nur einmal beschrieben werden.

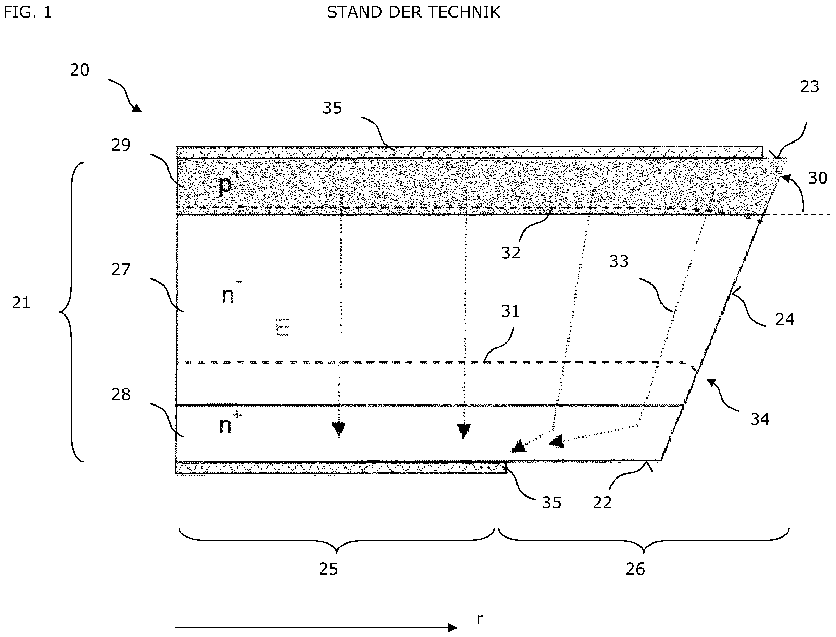

In Figur 1 ist ein Ausschnitt einer Querschnittsseitenansicht eines als Diode ausgebildeten Halbleiterbauelements 20 nach dem Stand der Technik dargestellt. Das Halbleiterbauelement 20 bzw. die Diode 20 umfasst einen Halbleiterkörper 21 mit einer ersten Seite 22, einer zweiten Seite 23 und einem Rand 24. Der Halbleiterkörper 21 untergliedert sich in radialer Richtung r in einen Innenbereich 25 und einen Randbereich 26.

Es sei darauf hingewiesen, dass der Innenbereich 25 des Halbleiterkörpers 21 flächenmäßig üblicherweise wesentlich größer als der Randbereich 26 ist, und dass der Randbereich 26 bei Draufsicht auf das Halbleiterbauelement 20 den Innenbereich 25 in Umfangsrichtung vollständig kreisförmig umgibt. Da der wesentliche Aspekt der vorliegenden Erfindung im Randbereich 26 liegt, ist in den Figuren aus Gründen der Übersichtlichkeit nur der Randbereich 26 und ein kleiner Ausschnitt des Innenbereichs 25 dargestellt.

Das in Figur 1 als Diode, insbesondere als Scheibenzellendiode ausgebildete Halbleiterbauelement 20 umfasst ferner in vertikaler Richtung eine Innenzone 27 mit einer Grunddotierung eines ersten Leitungstyps, die die Basis der Leistungsdiode 20 bildet, eine zwischen der ersten Seite 22 und der Innenzone 27 angeordnete erste Halbleiterzone 28 des ersten Leitungstyps sowie eine zwischen der zweiten Seite 23 und der Innenzone 27 angeordnete zweite Halbleiterzone 29 eines zweiten, zum ersten Leitungstyp komplementären Leitungstyps. In dem in Figur 1 dargestellten Beispiel ist die Innenzone 27 schwach n-dotiert, die erste Halbleiterzone hoch n-dotiert und die zweite Halbleiterzone 29 hoch p-dotiert. Die Ausdrücke "schwach dotiert" und "hoch dotiert" geben in an sich bekannter Weise an, dass die Dotierungskonzentrationen der ersten und zweiten Halbleiterzone 28 und 29 jeweils wesentlich höher sind als die Dotierungskonzentration der Innenzone 27. Übliche Dotierungskonzentrationen der hoch dotierten Gebiete liegen typischerweise zwischen etwa 10¹⁸ cm⁻³ bis etwa 10²¹ cm⁻³, wohingegen die Dotierungskonzentrationen der schwach dotierten Innenzone 27 gewöhnlich zwischen etwa 10¹² cm⁻³ bis etwa 10¹⁵ cm⁻³ beträgt. Die zweite Halbleiterzone 29 und die Innenzone 27 bilden in dem gezeigten Beispiel einen pn-Übergang.

Wie der Figur 1 ferner zu entnehmen ist, weist die Diode 20 bzw. der Halbleiterkörper 21 eine erste Randabschrägung des Rands 24 mit einem ersten Winkel 30 auf, unter dem die Erstreckungsebene des Übergangs, bei dem in Figur 1 gezeigten Beispiel des pn-Übergangs, von der zweiten Halbleiterzone 29 zur Innenzone 27 den Rand 24 schneidet. Die Randabschrägung erstreckt sich bei der dargestellten Diode 20 entlang des Rands der ersten und zweiten Halbleiterzone 28, 29 sowie der Innenzone 27 und somit entlang des gesamten Rands 24 des Halbleiterkörpers 21. Der Winkel 30 ist bezüglich des pn-Übergangs bei dem in Figur 1 dargestellten Beispiel der Diode 20 ein positiver Winkel, der vorzugsweise zwischen etwa 25° bis etwa 50° gewählt wird.

Weiter sind in Figur 1 die Eindringtiefe 31 und die Eindringtiefe 32 der Raumladungszone der Diode 20 in Richtung der ersten Halbleiterzone 28 (kathodenseitig) sowie in Richtung der zweiten Halbleiterzone 29 (anodenseitig) dargestellt. Es ist zu verstehen, dass die in der Figur 1 dargestellten Raumladungszonen lediglich prinzipielle Verläufe angeben und nicht den Fall der maximal möglichen Sperrspannung für den statischen Durchbruchsfall abbilden.

Ferner ist in Figur 1 durch entsprechende Pfeile 33 der Verlauf der Stromdichte im Durchlassfall dargestellt. Da die Fläche der zweiten Halbleiterzone 29 am Rand verhältnismäßig größer ist als die Fläche der ersten Halbleiterzone 28, kann am Rand in der Nähe des mit 34 gekennzeichneten Bereichs im Durchlassbetrieb und somit auch während der Ausräumphase eine erhöhte Stromdichte auftreten, die der im Halbleiterkörper 21 gespeicherten Ladung proportional ist. Durch diese Restladung im Randbereich bildet sich während der zeitlich auf die Durchlassphase folgenden Ausräumphase eine erhöhte Raumladung aus Elektronen aus, die im Bereich des Rands 24, insbesondere in der Nähe des mit 34 gekennzeichneten Bereichs zum dynamischen Avalanche führen kann.

An den jeweils äußeren Seiten- bzw. Kontaktflächen der ersten Seite 22 und der zweiten Seite 23 des Halbleiterkörpers 21 sind in an sich bekannter Weise Metallisierungen 35 vorgesehen, über die das Halbleiterbauelement 20 mit seiner Umgebung elektrisch verbindbar ist.

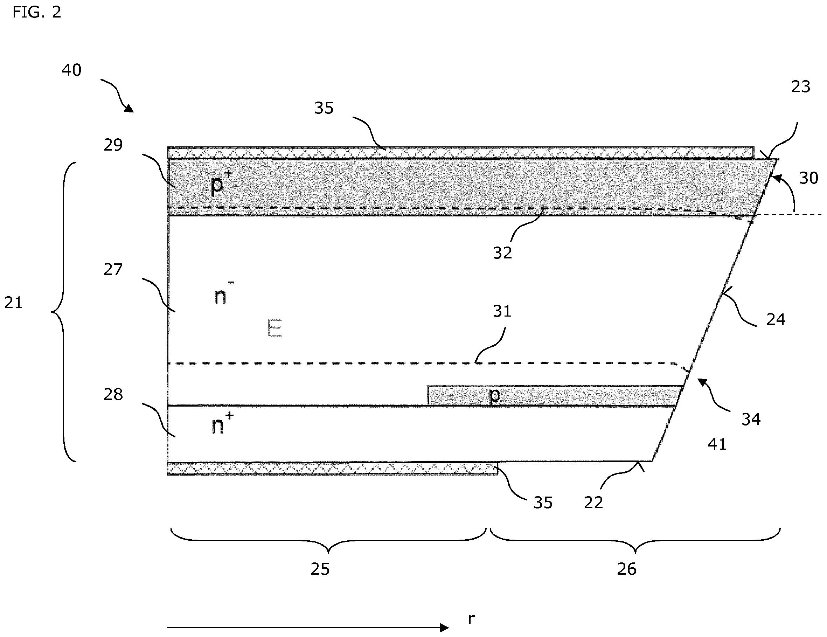

Ein Ausschnitt einer Querschnittsseitenansicht eines ersten nicht erfindungsgemäßen Ausführungsbeispiels eines als Diode, insbesondere als Scheibenzellendiode ausgebildeten Halbleiterbauelements 40 ist in Figur 2 dargestellt. Das Ausführungsbeispiel der Diode 40 unterscheidet sich von der in Figur 1 dargestellten Diode 20 lediglich dadurch, dass wenigstens eine vergrabene Halbleiterzone 41 des zweiten Ladungstyps mit einer Dotierungskonzentration, die höher ist als die Dotierungskonzentration der Innenzone 27, zwischen der ersten Halbleiterzone 28 und der Innenzone 27 vorgesehen ist. Die vergrabene Halbleiterzone 41 ist bei dem in Figur 2 dargestellten Ausführungsbeispiel p-dotiert. Insbesondere ist die vergrabene Halbleiterzone 41 als kreisförmiger p-Ring ausgeführt. Wie Figur 2 zu entnehmen ist, ist die vergrabene Halbleiterzone 41 im Wesentlichen lediglich in dem Randbereich 26 des Halbleiterkörpers 21 vorgesehen, um insbesondere dort die Stromdichte während des Ausschaltens zu verringern und somit das Auftreten des dynamischen Avalanche zu verzögern.

Während der Ausräumphase injiziert die vergrabene Halbleiterzone 41 in vorteilhafter Weise Löcher, welche die durch den dynamischen Avalanche erzeugten Elektronen kompensieren. Durch die Stromentlastung des Rands 24 bzw. des Randbereichs 26 werden überhöhte Feldstärkespitzen am Rand 24, insbesondere im Bereich des kathodenseitigen Bereichs 34, vermieden. Des Weiteren erlaubt die Herstellung der vergrabenen Halbleiterzone 41, zum Beispiel mittels Vorbelegung oder Ionenimplantation und einem sich anschließenden Hochtemperaturschritt, eine genaue Reproduzierbarkeit der Dotierung. Somit werden Streuungen der elektrischen Eigenschaften der Halbleiterbauelemente 40, insbesondere der sich einstellenden, zuvor beschriebenen Verhältnisse während der Ausräumphase vermieden bzw. wesentlich verringert.

Die Dimensionierung der vergrabenen Halbleiterzone 41 ist derart, dass sie oberhalb einer bestimmten, vorgebbaren Stromdichte Ladungsträger, in dem in Figur 2 gezeigten Fall Löcher, injizieren kann, die den lokal überhöhten Elektronenstrom zumindest teilweise kompensieren können. Wesentlich für diese Dimensionierung sind insbesondere die Auslegung der lateralen Erstreckung bzw. vertikale Tiefe und Dotierung der vergrabenen Halbleiterzone 41 sowie die Dotierungskonzentration der angrenzenden Innenzone 27. Bevorzugt beträgt das Maximum der Dotierungskonzentration der vergrabenen Halbleiterzone 41 zwischen etwa 2x10¹⁶ cm⁻³ und etwa 5x10¹⁷ cm⁻³, wobei sie bevorzugt ein Dotierprofil vom Gauss-Typ aufweist. Die vertikale Ausdehnung der vergrabenen Halbleiterzone 41 beträgt bevorzugt zwischen etwa 1,5 µm bis etwa 15 µm. Die laterale Erstreckung bzw. Breite des p-Rings 41 erstreckt sich hierbei wenigstens über den gesamten nicht metallisierten Bereich der Seite 22 und liegt vorzugsweise zwischen etwa 50 µm bis etwa 100 µm.

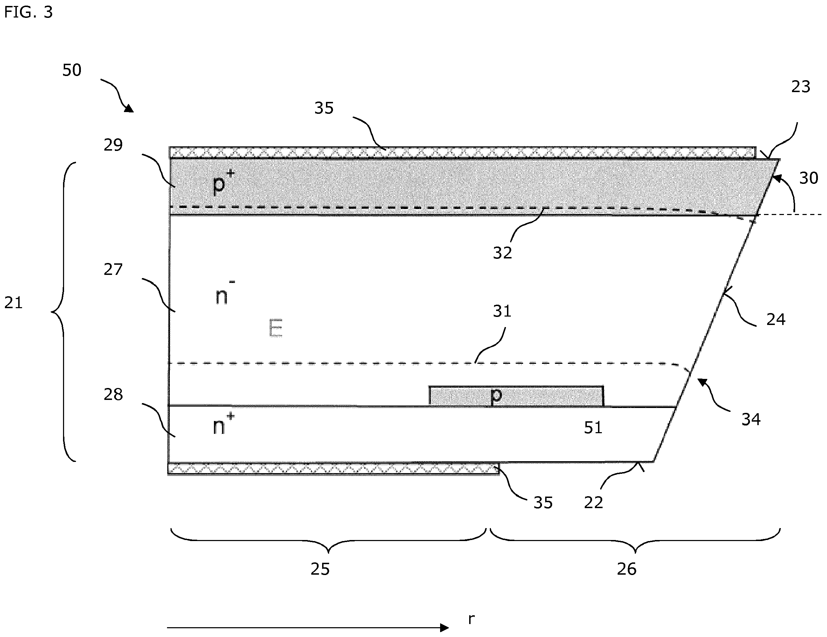

In Figur 3 ist ein Ausschnitt einer Querschnittsseitenansicht eines zweiten nicht erfindungsgemäßen Ausführungsbeispiels eines als Diode ausgebildeten Halbleiterbauelements 50 dargestellt. Wir der Figur 3 zu entnehmen ist, weist die Diode 50 eine vergrabene Halbleiterzone 51 auf, die in diesem Ausführungsbeispiel vom Rand 24 des Halbleiterkörpers 21 lateral beabstandet angeordnet ist. Der laterale Abstand beträgt bevorzugt zwischen etwa 30 µm und 200 µm. Durch diese Anordnung der vergrabenen Halbleiterzone 51 wird verhindert, dass die Feldstärkespitze in dem Bereich 34 nahe an die vergrabene Halbleiterzone 51 heranreichen kann. Im statischen Sperrfall könnte dies einen erhöhten Sperrstrom oder gar eine Verringerung der Sperrspannung zur Folge haben.

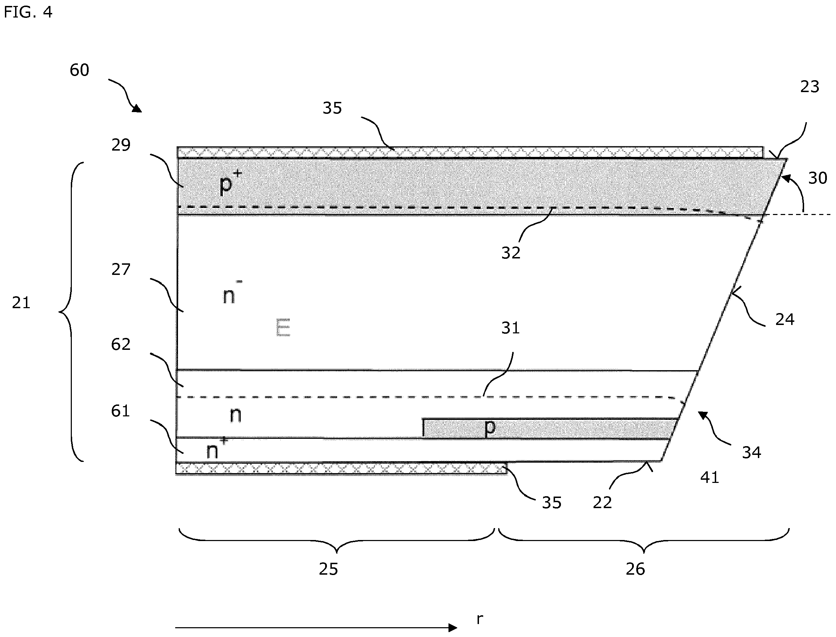

Eine weitere Möglichkeit um zu vermeiden, dass die Feldstärkespitzen in dem Bereich 34 zu nahe an die vergrabene Halbleiterzone 51 heranreichen können, ist in Figur 4 dargestellt, in der ein Ausschnitt einer Querschnittsseitenansicht eines dritten Ausführungsbeispiels eines als Diode ausgebildeten Halbleiterbauelements 60 gezeigt ist. Die Diode 60 weist ähnlich der in Figur 2 dargestellten Diode 40 eine vergrabene Halbleiterzone 41 auf, die bis an den Rand 24 reicht. Anders als bei der Diode 40 ist bei der Diode 60 jedoch die in Figur 2 dargestellte erste Halbleiterzone 28 nun aufgetrennt in eine hoch dotierte erste Halbleiterzone 61 niedriger Eindringtiefe und eine vorgelagerte Feldstoppzone 62 höherer Eindringtiefe. Mit anderen Worten ist zwischen der ersten Halbleiterzone 61 und der Innenzone 27 die parallel zur ersten Halbleiterzone 61 verlaufende Feldstoppzone 62 des ersten Leitungstyps mit einer Dotierungskonzentration angeordnet, die zwischen der Dotierungskonzentration der ersten Halbleiterzone 61 und der Dotierungskonzentration der Innenzone 27 liegt. Die Feldstoppzone 62 ist der vergrabenen Halbleiterzone 41 in Richtung der Innenzone 27 vorgelagert. Das Eindringen des elektrischen Felds in diese Puffer- bzw. Feldstoppzone 62 wird erlaubt, so dass die statische Sperrfähigkeit des Halbleiterbauelements 60 bei gleicher Dicke der Innenzone 27 somit erhöht wird. Die höhere Konzentration der positiven Raumladung innerhalb der Raumladungszone der Feldstoppzone 62 kompensiert im Sperrfall die negative dynamische Raumladung der Elektronen und wirkt so einer zu starken Feldüberhöhung im Bereich der Stelle 34 entgegen.

Die Puffer- bzw. Feldstoppzone 62 wird derart dimensioniert, dass ihre Dotierungskonzentration bevorzugt zwischen etwa 5x10¹⁴ cm⁻³ bis etwa 5x10¹⁶ cm⁻³ beträgt. Die Eindringtiefe der Feldstoppzone 62 beträgt bevorzugt zwischen etwa 10 µm bis etwa 70 µm. Ferner ist das Dotierungsprofil der Feldstoppzone 62 bevorzugt vom Gauss-Typ. Die Feldstoppzone kann in an sich bekannter Weise beispielsweise durch Vorbelegung oder Implantation eines Dotierstoffs, zum Beispiel Phosphor oder Selen, mit nachfolgender Eindiffusion hergestellt werden.

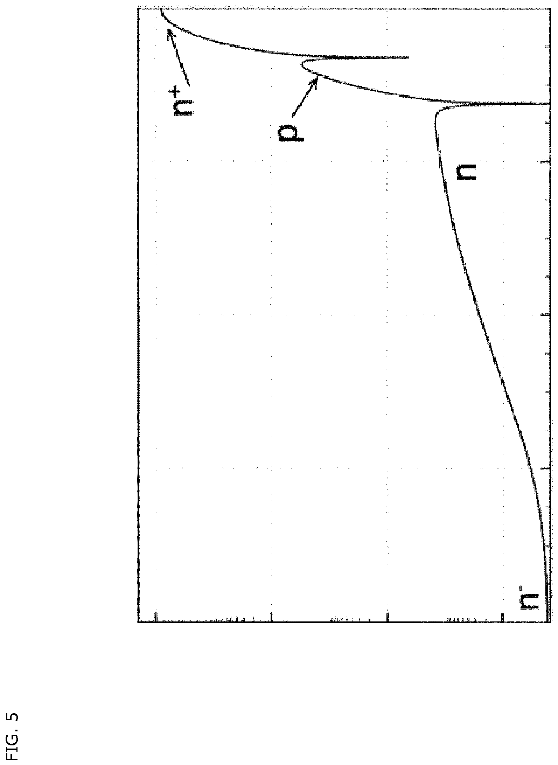

In Figur 5 ist ein beispielhaftes Dotierprofil des in Figur 4 gezeigten Halbleiterbauelements 60 dargestellt. Von links nach rechts sind in Figur 5 die Grunddotierung der schwach n-dotierten Innenzone 27, die höher n-dotierte Feldstoppzone 62, die noch höher p-dotierte vergrabene Halbleiterzone 41 und schließlich die hoch n-dotierte erste Halbleiterzone 61 dargestellt.

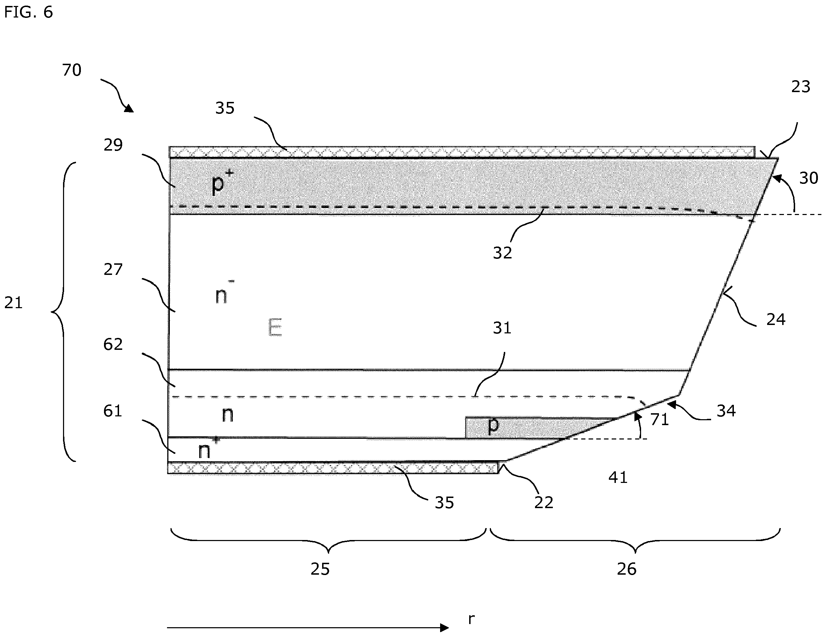

In Figur 6 ist ein Ausschnitt einer Querschnittsseitenansicht eines als Diode ausgebildeten erfindungsgemäßen Halbleiterbauelements 70 dargestellt. Die Diode 70 weist gegenüber der in Figur 4 gezeigten Diode 60 eine zweite Randabschrägung mit einem zweiten, flacheren Winkel 71 bezüglich des Übergangs von der ersten Halbleiterzone 61 zur Innenzone 27 bzw. zur Feldstoppzone 62 auf. Die zweite Randabschrägung erstreckt sich bei dem gezeigten Ausführungsbeispiel entlang des Rands der ersten Halbleiterzone 61 und der vergrabenen Halbleiterzone 41, wobei der Betrag des zweiten Winkels 71 kleiner ist als der Betrag des ersten Winkels 30 und vorzugsweise zwischen etwa 1° bis etwa 5° liegt. Bezüglich des n⁺n-Übergangs von der ersten Halbleiterzone 61 zur Feldstoppzone 62 ist der Winkel 71 ein negativer Winkel. Die Austrittsstelle 34 der Raumladungszone an der Seite der ersten Halbleiterzone 61 liegt im Bereich der Feldstoppzone 62 und hat an dieser Stelle einen flachen Winkel, was die Höhe der Feldstärkespitze durch die Verbreiterung der Raumladungszone verringert. Es ist zu verstehen, dass der in Figur 6 dargestellte Austritt nicht die Verhältnisse der maximal anliegenden Sperrspannung zeigt, sondern lediglich zur prinzipiellen Verdeutlichung der allgemeinen Lage und Form der Raumladungszone dient.

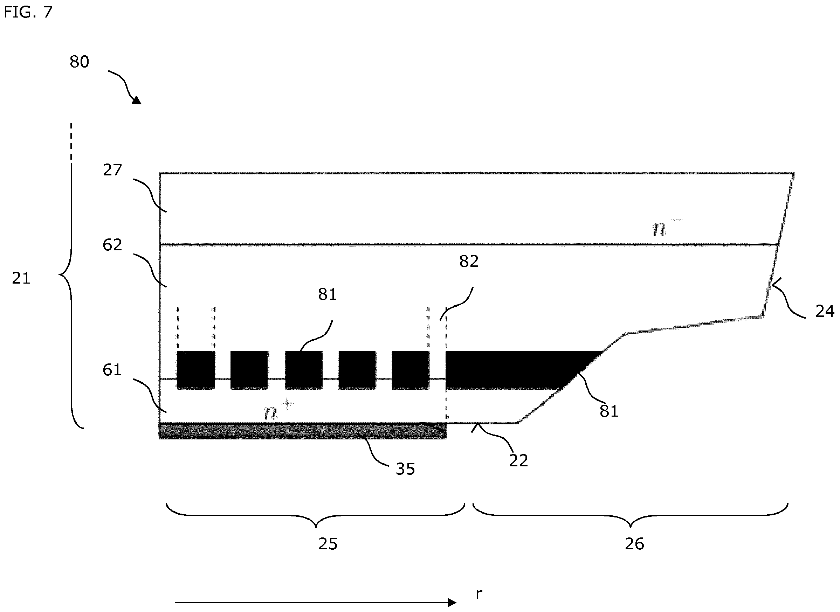

In Figur 7 ist ein Ausschnitt einer Querschnittsseitenansicht eines als Diode ausgebildeten, nicht erfindungsgemäßen Halbleiterbauelements 80 dargestellt. Die Diode 80 weist im Gegensatz zur vergrabenen Halbleiterzone 41 der in Figur 6 dargestellten Diode 70 mehrere, in einer Ebene angeordnete und zueinander lateral beabstandete, vergrabene Halbleiterzonen 81 auf. Wie in Figur 7 zu erkennen ist, müssen sich die vergrabenen Halbleiterzonen 81 nicht auf den Randbereich 26 des Halbleiterkörpers 21 beschränken, sondern können vielmehr auch über den Innenbereich 25 des Halbleiterkörpers 21 und somit über die gesamte Kathodenfläche verteilt angeordnet sein. Eine solche Anordnung erhöht nicht nur die Abschaltrobustheit des Halbleiterbauelements im Randbereich, sondern zusätzlich auch in der gesamten Fläche der Diode 80.

In einer Draufsicht auf den Halbleiterkörper 21 stellen die einzelnen vergrabenen Halbleiterzonen 81 bei dem in Figur 7 gezeigten Ausführungsbeispiel konzentrische Ringe um den in Figur 7 nicht sichtbaren Mittelpunkt des Halbleiterkörpers 21 dar. Hierzu sind die Öffnungen bzw. Unterbrechungen 82 zwischen den vergrabenen Halbleiterzonen 81 zum Beispiel als Streifen mit einer Breite von nicht größer als etwa 6 µm, bevorzugt zwischen etwa 2 µm und 6 µm, ausgebildet. Die letzte Öffnung 82 vor dem im Randbereich 26 vergrabenen äußersten Ring der Halbleiterzonen 81 kann kleiner sein als die übrigen Öffnungen 82. In dem in Figur 7 dargestellten Ausführungsbeispiel der Diode 80 beträgt die Breite der Öffnung 82 vor dem im Randbereich 26 vergrabenen äußersten Ring der Halbleiterzonen 81 etwa 4,5 µm. Die Breite der vergrabenen Halbleiterzonen 81 außer dem im Randbereich 26 vergrabenen äußersten Ring der Halbleiterzonen 81 beträgt bei dem dargestellten Ausführungsbeispiel etwa 48 µm. In bevorzugter Weise erstreckt sich der äußerste Ring der Halbleiterzonen 81 vom Rand 24 des Halbleiterkörpers 21 in lateraler Richtung nach innen wenigstens bis zur Metallisierung 35.

Die Öffnungen bzw. Unterbrechungen 82 können auch als zweidimensionale Löcheranordnung in einer ganzflächigen, vergrabenen Halbleiterzone vorgesehen sein. In diesem Fall kann der Durchmesser dieser so genannten "Shorts" größer sein als die vorgenannte Breite der Öffnungs- bzw. Unterbrechungsstreifen, bevorzugt bis zu etwa 10 µm. Insbesondere kann der Durchmesser der Shorts auch zum Rand 24 des Halbleiterbauelements 80 hin variieren, zum Beispiel kleiner werden.

Herstellbar ist eine derartige Struktur mit Unterbrechungen bzw, Öffnungen 82 in der vergrabenen Halbleiterzone 81 sowie eine zweidimensionale Löcheranordnung zum Beispiel durch eine maskierte Borimplantation mit hoher Implantationsenergie und mit einem nachfolgenden Ausheilschritt, optional je nach gewünschter Eindringtiefe für die vergrabene Schicht auch mit einem nachfolgenden Diffusionsschritt. Anstelle von Bor sind als Akzeptor auch Gallium oder Aluminium möglich. Die Herstellung ist auch möglich mit einer Vorbelegung durch eine maskierte Bor-Diffusion und einem anschließenden Eintreibschritt.

In bevorzugter Verwendung ist das erfindungsgemäße Halbleiterbauelement als schnell schaltende Scheibenzellendiode mit guter Hochspannungsverträglichkeit und verbesserter Abschaltrobustheit ausgeführt.

### Bezugszeichenliste:

- 20: Halbleiterbauelement, Diode
- 21: Halbleiterkörper
- 22: Erste Seite
- 23: Zweite Seite
- 24: Rand
- 25: Innenbereich
- 26: Randbereich
- 27: Innenzone
- 28: Erste Halbleiterzone
- 29: Zweite Halbleiterzone
- 30: Erster Randabschrägungswinkel
- 31: Kathodenseitige Eindringtiefe der Raumladungszone
- 32: Anodenseitige Eindringtiefe der Raumladungszone
- 33: Stromdichteverlauf
- 34: Stelle erhöhter Stromdichte
- 40: Halbleiterbauelement, Diode
- 41: Vergrabene Halbleiterzone
- 50: Halbleiterbauelement, Diode
- 51: Vergrabene Halbleiterzone
- 60: Halbleiterbauelement, Diode
- 61: Erste Halbleiterzone
- 62: Feldstoppzone
- 70: Halbleiterbauelement, Diode
- 71: Zweiter Winkel
- 80: Halbleiterbauelement, Diode
- 81: Vergrabene Halbleiterzone
- 82: Unterbrechungen, Öffnungen
- n: Dotierung eines ersten Leitungstyps
- p: Dotierung eines zweiten, zum ersten Leitungstyp komplementären Leitungstyps
- r: Radius

## Patentansprüche

1. Halbleiterbauelement, aufweisend:
einen Halbleiterköper (21) mit einer ersten Seite (22), einer zweiten Seite (23) und einem Rand (24), eine Innenzone (27) mit einer Grunddotierung eines ersten Leitungstyps, eine erste, zwischen der ersten Seite (22) und der Innenzone (27) angeordnete Halbleiterzone (61) des ersten Leitungstyps mit einer Dotierungskonzentration, die höher ist als die der Innenzone (27), eine zweite, zwischen der zweiten Seite (23) und der Innenzone (27) angeordnete Halbleiterzone (29) eines zweiten, zum ersten Leitungstyp komplementären Leitungstyps mit einer Dotierungskonzentration, die höher ist als die der Innenzone (27),
wenigstens eine erste Randabschrägung, die sich in einem ersten spitzen Winkel (30) zur Erstreckungsebene des Übergangs von der zweiten Halbleiterzone (29) zur Innenzone (27) wenigstens entlang des Rands (24) der zweiten Halbleiterzone (29) und der Innenzone (27) erstreckt, eine zweite Randabschrägung mit einem zweiten spitzen Winkel (71) bezüglich des Übergangs von der ersten Halbleiterzone (61) zur Innenzone (27), wobei der Betrag des zweiten spitzen Winkels (71) kleiner ist als der Betrag des ersten spitzen Winkels (30), wobei der erste spitze Winkel (30) ein positiver Winkel ist und der zweite spitze Winkel (71) ein negativer Winkel ist;
**dadurch gekennzeichnet, dass**
wenigstens eine vergrabene Halbleiterzone (41) des zweiten Leitungstyps mit einer Dotierungskonzentration, die höher ist als die der Innenzone (27), zwischen der ersten Halbleiterzone (61) und der Innenzone (27) vorgesehen ist und sich im Wesentlichen parallel zur ersten Halbleiterzone (61) erstreckt und lediglich in einem Randbereich (26) des Halbleiterkörpers (21) vorgesehen ist,
und dass sich die zweite Randabschrägung wenigstens entlang des Rands (24) der ersten Halbleiterzone (61) und der vergrabenen Halbleiterzone (41) erstreckt.

2. Halbleiterbauelement nach Anspruch 1,
**dadurch gekennzeichnet, dass**
die vergrabene Halbleiterzone (41) eine maximale Dotierungskonzentration bevorzugt zwischen etwa 2x10¹⁶ cm⁻³ und etwa 5x10¹⁷ cm⁻³ und eine laterale Erstreckung bevorzugt zwischen etwa 1,5 µm und etwa 15 µm aufweist.

3. Halbleiterbauelement nach einem der vorhergehenden Ansprüche,
**dadurch gekennzeichnet, dass**
das Halbleiterbauelement als Scheibenzellendiode (70) ausgebildet ist.

## Claims

1. A semiconductor device, comprising:
a semiconductor body (21) having a first side (22), a second side (23) and an edge (24), an inner zone (27) having a base doping of a first conductivity type, a first semiconductor zone (61) - arranged between the first side (22) and the inner zone (27) - of the first conductivity type having a doping concentration that is higher than that of the inner zone (27), a second semiconductor zone (29) - arranged between the second side (23) and the inner zone (27) - of a second conductivity type, which is complementary to the first conductivity type and has a doping concentration that is higher than that of the inner zone (27), at least one first edge bevel, which extends at a first acute angle (30) with respect to the extension plane of the transition from the second semiconductor zone (29) to inner zone (27) at least along the edge (24) of the second semiconductor zone (29) and the inner zone (27), and a second edge bevel having a second acute angle (71) with respect to the transition from the first semiconductor zone (61) to the inner zone (27),
wherein the magnitude of the second acute angle (71) is smaller than the magnitude of the first acute angle (30), wherein the first acute angle (30) is a positive angle and the second acute angle (71) is a negative angle;
**characterized in that**
at least one buried semiconductor zone (41) of the second conductivity type with a doping concentration higher than that of the inner zone (27) is provided between the first semiconductor zone (61) and the inner zone (27) and extends essentially parallel to the first semiconductor zone (61) and is provided only in an edge region (26) of the semiconductor body (21),
and that the second edge bevel extends at least along the edge (24) of the first semiconductor zone (61) and the buried semiconductor zone (41).

2. The semiconductor device according to claim 1,
**characterized in that**
the buried semiconductor zone (41) has a maximum doping concentration that is preferably between about 2x10¹⁶ cm⁻³ and about 5x10¹⁷ cm⁻³, and a lateral extent preferably between about 1.5 µm and about 15 µm.

3. The semiconductor device (100) according to any of the preceding claims, **characterized in that**
the semiconductor device is designed as a disk cell diode (70).

## Revendications

1. Élément semi-conducteur, présentant
un corps semi-conducteur (21) pourvu d'un premier côté (22), d'un deuxième côté (23) et d'un bord (24), une zone interne (27) pourvue d'un dopage de base d'un premier type de conductivité, une première zone semi-conductrice (61), agencée entre le premier côté (22) et la zone interne (27), du premier type de conductivité, pourvue d'une concentration de dopage qui est supérieure à celle de la zone interne (27), une deuxième zone semi-conductrice (29), agencée entre le deuxième côté (23) et la zone interne (27), d'un deuxième type de conductivité complémentaire au premier type de conductivité, pourvue d'une concentration de dopage qui est supérieure à celle de la zone interne (27), au moins un premier biseau de bord, qui s'étend selon un premier angle aigu (30) par rapport au plan d'extension de la transition de la deuxième zone semi-conductrice (29) à la zone interne (27) au moins le long du bord (24) de la deuxième zone semi-conductrice (29) et de la zone interne (27), un deuxième biseau de bord formant un deuxième angle aigu (71) par rapport à la transition de la première zone semi-conductrice (61) à la zone interne (27),
l'amplitude du deuxième angle aigu (71) étant inférieure à l'amplitude du premier angle aigu (30), le premier angle aigu (30) étant un angle positif et le deuxième angle aigu (71) étant un angle négatif ;
**caractérisé en ce que**
au moins une zone semi-conductrice enfouie (41) du deuxième type de conductivité, pourvue d'une concentration de dopage qui est supérieure à celle de la zone interne (27), est située entre la première zone semi-conductrice (61) et la zone interne (27) et s'étend de manière essentiellement parallèle à la première zone semi-conductrice (61) et n'est située que dans une zone de bord (26) du corps semi-conducteur (21)
et **en ce que** le deuxième biseau de bord s'étend au moins le long du bord (24) de la première zone semi-conductrice (61) et de la zone semi-conductrice enfouie (41).

2. Élément semi-conducteur selon la revendication 1,
**caractérisé en ce que**
la zone semi-conductrice (41) présente une concentration de dopage maximale de préférence entre environ 2x10¹⁶ cm⁻³ et environ 5x10¹⁷ cm⁻³ et une étendue latérale de préférence entre environ 1,5 µm et environ 15 µm.

3. Élément semi-conducteur selon l'une quelconque des revendications précédentes,
**caractérisé en ce que**
l'élément semi-conducteur est conçu sous forme de diode à cellules circulaires (70).
